# FASCICULE DE BREVET EUROPEEN

(11) **EP 0 447 729 B1**
(45) Date de publication et mention de la délivrance du brevet: **19.05.1993**
(21) Numéro de dépôt: 90403391.7
(22) Date de dépôt: 29.11.1990
(51) Int. Cl.: G01R 19/17

(54) **Comparateur à seuil immunisé contre le bruit**
Gegen Rauschen geschützter Schwellwertdetektor
Level detector hardened against noise

(30) Priorité: 05.12.1989 FR 8916044
(43) Date de publication de la demande: 25.09.1991
(73) Titulaire: SGS-THOMSON MICROELECTRONICS S.A., 94250 Gentilly (FR)
(72) Inventeur: Smith, Alan, F-75116 Paris (FR)
(74) Mandataire: Schmit, Christian Norbert Marie

(56) Documents cités:
- US-A- 4 356 481
- PATENT ABSTRACTS OF JAPAN, vol. 4, no. 40 (E-4)[522], 28 novembre 1980, page 61 E 4; & JP-A-55 11 626 (HITACHI SEISAKUSHO K.K.) 26-01-1980
- PATENT ABSTRACTS OF JAPAN, vol. 4, no. 112 (E-21)[594], 12 août 1980, page 22 E 21; & JP-A-55 68 729 (MITSUBISHI DENKI K.K.) 23-05-1980

## Description

L'invention concerne les circuits intégrés, et plus particulièrement la manière de réaliser un comparateur à seuil qui soit immunisé contre le bruit, notamment le bruit constitué par les variations de tension d'alimentation Vcc du circuit intégré ou les variations de potentiel de masse électrique.

Dans un comparateur à seuil, le seuil à partir duquel le comparateur bascule dans un sens ou dans l'autre est plus ou moins fonction de la tension d'alimentation du comparateur, ou plus exactement de la différence entre cette tension et la masse. Mais il peut y avoir des fluctuations dans la tension d'alimentation ou dans le potentiel de masse (ce dernier potentiel étant plus ou moins bien réparti à travers le circuit intégré). Ces fluctuations, qu'on peut appeler bruit d'alimentation, sont gênantes pour le fonctionnement du comparateur.

C'est tout particulièrement le cas par exemple dans un circuit de comptage d'alternances d'un signal alternatif ou dans un circuit de comptage des passages d'un signal périodique au dessus d'un seuil déterminé. Le comparateur est alors utilisé pour détecter les passages au dessus d'un seuil déterminé. Mais si la tension de référence varie en cours de comparaison on risque d'avoir un double comptage là où on ne devrait détecter qu'un seul dépassement de seuil. Le compte est alors faux, ce qui est un inconvénient très important.

La présente invention a pour but de proposer un circuit de comparaison qui ne comporte pas les inconvénients de ceux de la technique antérieure.

Selon l'invention, on propose un comparateur à seuil protégé du bruit, comprenant une entrée de signal destinée à recevoir un signal de niveau variable, caractérisé en ce qu'il comprend au moins une capacité d'entrée reliée à l'entrée de signal, deux inverseurs à seuil ayant chacun une entrée reliée à la capacité, ces inverseurs ayant des seuils de basculement proches l'un de l'autre, ces seuils correspondant à une valeur de tension d'entrée Vbias+v pour l'un et Vbias-v' pour l'autre, v et v' faibles devant la tension d'alimentation Vcc du comparateur, les sorties des inverseurs étant reliées l'une à une entrée de basculement d'une bascule de type RS et l'autre à l'entrée de rétablissement de cette bascule, de manière à provoquer le basculement de la bascule lors d'un changement d'état de l'un des inverseurs par suite du dépassement de Vbias+v par le signal d'entrée et le rétablissement lors du changement d'état de l'autre inverseur par suite du retour du signal d'entrée au dessous de Vbias-v'.

De préférence, la tension Vbias est une tension de polarisation définie par la sortie d'un troisième inverseur ayant son entrée rebouclée sur sa sortie, cette sortie étant reliée aux entrées des deux premiers inverseurs, chacun des trois inverseurs comprenant deux transistors en série et les géométries des transistors des inverseurs étant choisis de telle sorte que le rapport entre la géométrie du premier transistor et la géométrie du deuxième pour le premier inverseur soit légèrement différent du rapport correspondant pour le deuxième inverseur, le rapport correspondant pour le troisième inverseur étant compris entre les deux premiers rapports.

Par l'expression classique "géométrie" d'un transistor, on entend le rapport W/L entre sa largeur de canal W et sa longueur de canal L.

Dans une réalisation pratique avantageuse de l'invention, chacun des trois inverseurs comprend un transistor à canal N en série avec un transistor à canal P. L'entrée de l'inverseur peut être constituée par exemple par la grille du transistor à canal N. La grille du transistor à canal P peut être commandée par une tension de référence Vref commune à tous les inverseurs ou être reliée à l'entrée de l'inverseur.

Le circuit le plus simple mettant en oeuvre l'invention pourra comporter pour chaque inverseur un transistor à canal P en série avec un transistor à canal N; les grilles de tous les transistors P (ou au contraire N) sont commandées par la même tension de référence Vref; tous les transistors P ont le même rapport largeur/longueur de canal; les transistors N des deux premiers inverseurs ont des rapports largeur sur longueur de canal légèrement différents l'un de l'autre, et le troisième inverseur a un rapport largeur sur longueur de canal compris entre ceux des deux premiers inverseurs.

Enfin, une variante de réalisation consiste à prévoir non pas un troisième inverseur pour établir une tension de polarisation Vbias, mais deux "troisièmes inverseurs" (qu'on appellera ci-après troisième et quatrième inverseurs) pour établir deux tensions de polarisation Vbias+v et Vbias-v' appliquées respectivement à l'entrée du premier inverseur et du deuxième inverseur. Dans ce cas, il y a deux capacités reliées l'une entre l'entrée de signal et l'entrée du premier inverseur, l'autre entre l'entrée de signal et l'entrée du deuxième inverseur. Le premier inverseur a de préférence des transistors identiques à ceux du troisième; et le deuxième a des transistors identiques à ceux du quatrième mais différents du premier et du troisième, le troisième et le quatrième inverseur des tensions de polarisation légèrement différentes l'une de l'autre.

D'autres caractéristiques et avantages de l'invention apparaîtront à la lecture de la description détaillée qui suit et qui est faite en référence aux dessins annexés dans lesquels:
- la figure 1 représente un schéma classique de comparateur utilisé en détecteur de dépassement de niveau, en vue par exemple de compter des dépassements;
- la figure 2 représente un schéma de principe d'un comparateur selon l'invention;
- la figure 3 représente une réalisation de circuit préférentielle selon l'invention.
- la figure 4 représente une variante de réalisation;
- la figure 5 représente une autre variante de réalisation.

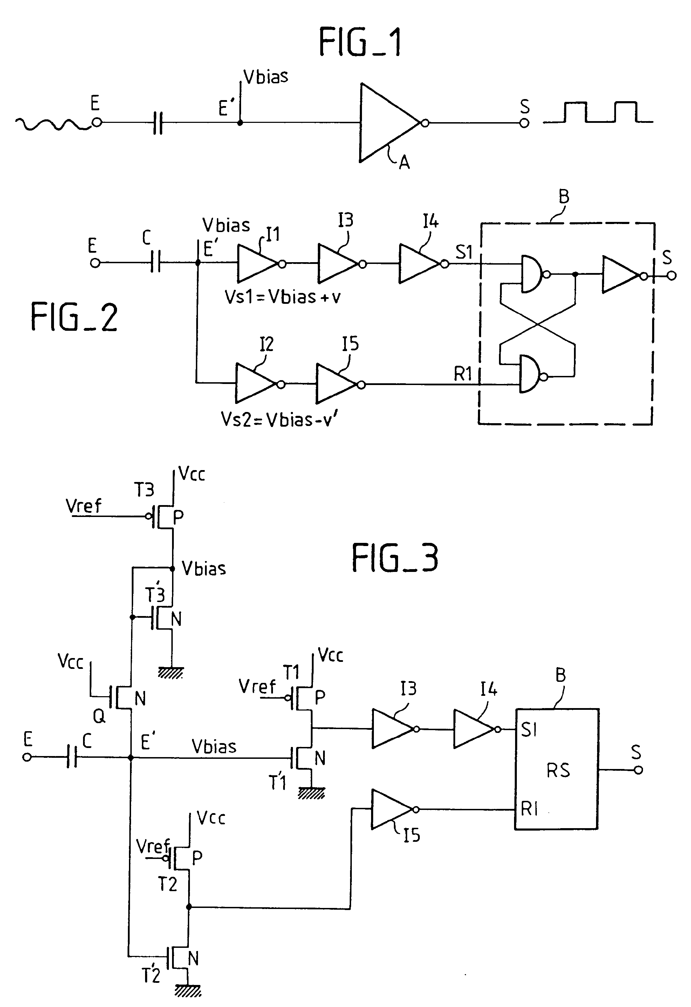

Le schéma classique de la figure 1 comprend une entrée de signal E, destinée à recevoir un signal variable, tel qu'un signal périodique alternatif; on veut compter par exemple le nombre de fois où ce signal dépasse un niveau de référence Vbias. Un comparateur à seuil A est utilisé. L'entrée de signal E est reliée à une capacité C qui est par ailleurs reliée à l'entrée du comparateur à seuil A. L'entrée du comparateur est polarisée à une tension continue fixe Vbias qui définit le seuil de comparaison. La sortie S du comparateur fournit un niveau logique 1 à chaque fois qu'il y a dépassement du seuil Vbias par le signal d'entrée.

Comme on l'a expliqué ci-dessus, si les potentiels d'alimentation (Vcc et masse) du circuit intégré changent, le potentiel de référence Vbias risque de changer aussi; et cela peut se produire alors que le signal d'entrée est très près du niveau Vbias. Il y a risque de comptages multiples pour un seul dépassement réel du niveau Vbias par le signal d'entrée.

La figure 2 représente un schéma théorique expliquant une manière de remédier à cet inconvénient.

Sur la figure 2, on connecte l'entrée E par une capacité de découplage C à une entrée commune E' de deux inverseurs à seuil I1 et I2. L'entrée E' est polarisée par une tension Vbias, mais les seuils des inverseurs I1 et I2 sont légèrement différents de Vbias: le seuil de l'inverseur I1 est Vbias+v, celui de l'inverseur I2 est Vbias-v'. Les tensions v et v' sont des tensions faibles devant la tension d'alimentation Vcc. Elles pourraient être égales (v=v'), mais pas nécessairement.

La sortie de l'inverseur I1 est reliée, directement ou par l'intermédiaire d'inverseurs en cascade (I3, I4 sur la figure) à l'entrée de basculement S1 d'une bascule B de type RS. La sortie de l'inverseur I2 est reliée à l'entrée de rétablissement R1 de la bascule, par l'intermédiaire d'un ou plusieurs inverseurs (I5) en cascade; le nombre d'inverseurs entre I2 et l'entrée R1 est de parité inverse du nombre d'inverseurs en cascade entre I1 et l'entrée S1.

Ce n'est que lorsque le niveau de signal d'entrée dépasse Vbias+v que la bascule B bascule sous l'effet d'un changement d'état de son entrée S1; l'état de la bascule n'est ensuite restauré que lorsque l'entrée de rétablissement R1 voit son niveau changer sous l'effet du passage de la tension d'entrée au dessous du niveau Vbias-v'.

Même si les tensions d'alimentation fluctuent par suite de la présence de bruit dans l'alimentation ou la masse, il n'y a alors que très peu de risques de fausses détections de dépassement de seuil.

La figure 3 représente un mode de réalisation préférentiel de l'invention, permettant de mettre en oeuvre d'une manière extrêmement simple cette sécurité contre le bruit.

Dans la réalisation de la figure 3, conforme au schéma bloc de la figure 2, la capacité C est reliée entre l'entrée de signal E et l'entrée commune E' de deux inverseurs I1 et I2 constitués chacun par un ensemble de deux transistors en série; la tension de polarisation Vbias est fournie par un troisième inverseur dont l'entrée est rebouclée sur sa sortie, la sortie fournissant la tension Vbias.

Plus précisément, l'inverseur I1 comprend un transistor MOS à canal P T1 en série avec un transistor MOS à canal N T'1. Le transistor à canal P est connecté par sa source à Vcc, le transistor à canal N est connecté par sa source à la masse; la grille du transistor à canal P T1 est commandée par une tension de référence Vref. La grille du transistor T'1 constitue l'entrée de l'inverseur et est reliée à la borne E'. La sortie de l'inverseur est prélevée sur les drains réunis des transistors T1 et T'1. C'est elle qui est reliée, par l'intermédiaire ou non d'autres inverseurs (I3, I4) à une entrée S1 de la bascule RS.

L'inverseur I2 est constitué exactement comme l'inverseur I1, avec des transistors T2 et T'2. Toutefois, comme on le verra, l'inverseur I2 diffère de l'inverseur I1 par les dimensions de ses transistors. La sortie de l'inverseur I2, prise sur les drains réunis de T2 et T'2, est reliée à l'autre entrée R1 de la bascule B.

Le troisième inverseur mentionné précédemment, qui établit la tension de polarisation Vbias sur l'entrée E', comprend un transistor T3 (canal P) en série avec un transistor T'3 (canal N) entre l'alimentation Vcc et la masse. La grille du transistor T3 est commandée par la même tension de référence Vref que les grilles des transistors T1 et T2 des inverseurs I1 et I2. La grille du transistor T'3 est reliée aux drains réunis de T3 et T'3; elle constitue à la fois l'entrée et la sortie de l'inverseur, sur laquelle est engendrée automatiquement la tension de polarisation Vbias. Cette sortie est reliée à travers un transistor Q (jouant le rôle de résistance) à l'entrée E' des inverseurs I1 et I2. Q est par exemple un transistor à canal N ayant sa grille reliée à Vcc et ayant un faible rapport largeur/longueur de canal (transistor dit "long").

Dans ce montage, la tension de polarisation Vbias est déterminée automatiquement par la tension Vref et par les dimensions des transistors T3 et T'3 : la valeur Vref (ou plus exactement Vcc-Vref) impose le courant dans le transistor T3, ce courant étant proportionnel à la géométrie du transistor T3 pour une technologie donnée, c'est-à-dire pour une mobilité de porteurs donnée, une épaisseur d'oxyde de grille donnée, et une tension de seuil donnée des transistors. Ce courant, en circulant dans le transistor T'3 engendre une tension grille-source Vbias proportionnelle à ce courant et inversement proportionnelle à la géométrie du transistor T'3. On comprend donc que Vbias soit proportionnel au rapport entre les géométries des transistors P et N de l'inverseur.

Dans les inverseurs I1 et I2, la tension de référence Vref appliquée au transistor à canal P et la tension de polarisation Vbias appliquée au transistor à canal N tendraient à imposer un équilibre similaire dans lequel le même courant circule dans le transistor à canal P et le transistor à canal N, si toutefois les rapports entre les géométries du transistor à canal P et du transistor à canal N dans ces inverseurs étaient exactement les mêmes que pour l'inverseur T3, T'3.

Si on modifie ces géométries on ne peut plus réaliser l'équilibre et on constitue des inverseurs qui ont des tensions de seuil de basculement différents de la tension Vbias.

Plus précisément, si les géométries des transistors T3 et T'3 sont dans un rapport K3 = (W3/L3)/(W'3/L'3), on choisira les géométries de T1 et T'1 dans un rapport K1 = (W1/L1)/(W'1/L'1) légèrement supérieur à K3, et les géométries de T2 et T'2 dans un rapport K2 = (W2/L2)/(W'2/L'2) légèrement inférieur à K3.

Ces choix peuvent s'effectuer en agissant sur les largeurs (W) ou sur les longueurs (L) de canal des transistors à canal N ou des transistors à canal P. Le plus simple est par exemple de choisir des inverseurs tous identiques à l'exception des largeurs de canal des transistors N.

Dans un exemple de réalisation pratique, on a trouvé que des largeurs de canal de transistors N dans un rapport 27/20 entre T1 et T3 et 17/20 entre T2 et T3 convenaient bien.

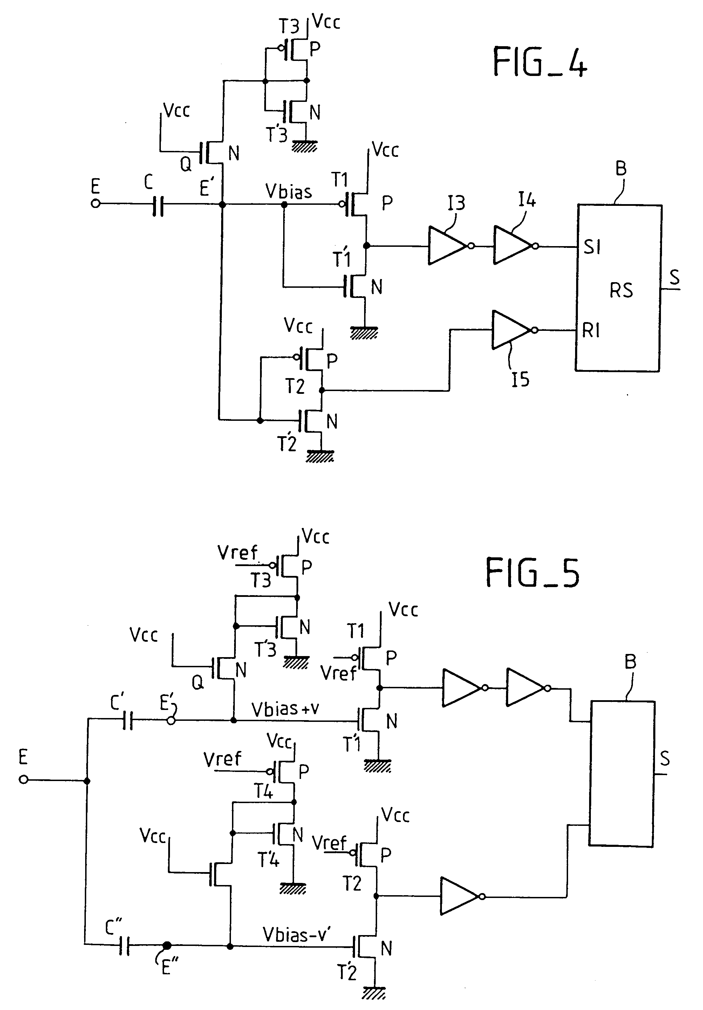

Dans une variante de réalisation représentée à la figure 4, les inverseurs sont encore constitués par un transistor à canal P en série avec un transistor à canal N entre Vcc et la masse; mais au lieu que le transistor à canal P ait sa grille reliée à une source de tension de référence Vref commune aux trois inverseurs, il a sa grille reliée à la grille du transistor à canal N, c'est-à-dire à l'entrée de l'inverseur. Le fonctionnement est le même et la valeur des seuils de basculement dépend là encore des rapports des géométries des transistors à canal N et à canal P pour les différents inverseurs: le rapport pour le troisième inverseur (T3, T'3) est compris entre les rapports correspondants pour les deux premiers inverseurs (T1, T'1 et T2, T'2).

Dans une dernière variante de réalisation, représentée à la figure 5, on utilise un troisième inverseur pour définir une tension de polarisation Vbias+v et un quatrième inverseur pour définir une tension de polarisation Vbias-v'. Ces tensions de polarisation sont appliquées l'une à l'entrée E' du premier inverseur et l'autre à l'entrée E'' du deuxième; les entrées des deux premiers inverseurs sont en effet déconnectées et reliées chacune par une capacité respective C', C'' à l'entrée de signal E.

Les quatre inverseurs sont constitués de la même manière que dans les réalisations déjà décrites, le quatrième inverseur comprenant un transistor à canal P T4 en série avec un transistor à canal N T'4.

Le premier inverseur a de préférence des géométries identiques à celles du troisième et le deuxième inverseur a des géométries de transistors identiques à celles du quatrième mais légèrement différentes de celles des premiers et troisième inverseur, cette différence établissant la différence entre les tensions de polarisation donc entre les seuils de basculement des inverseurs.

## Revendications

1. Comparateur à seuil protégé du bruit, comprenant une entrée de signal (E) destinée à recevoir un signal de niveau variable, caractérisé en ce qu'il comprend au moins une capacité d'entrée (C) reliée à l'entrée de signal (E), deux inverseurs à seuil (I1, I2) ayant chacun une entrée reliée à la capacité (C), ces inverseurs (I1, I2) ayant des seuils de basculement proches l'un de l'autre qui correspondent à une tension d'entrée Vbias + v pour l'un et Vbias - v' pour l'autre, v et v' faibles devant la tension d'alimentation Vcc du comparateur, les sorties des inverseurs (I1, I2) étant reliées l'une à une entrée de basculement (S1) d'une bascule (B) de type RS et l'autre à l'entrée de rétablissement (R1) de cette bascule (B) de manière à provoquer le basculement de la bascule (B) lors d'un changement d'état de l'un des inverseurs par suite du dépassement de Vbias + v par le signal d'entrée et le rétablissement lors du changement d'état de l'autre inverseur par suite du retour du signal d'entrée au dessous de Vbias - v'.

2. Comparateur selon la revendication 1, caractérisé en ce que la tension Vbias est définie par la sortie d'au moins un troisième inverseur (T3, T'3) ayant son entrée rebouclée sur sa sortie, cette sortie étant reliée aux entrées des deux premiers inverseurs, chacun des trois inverseurs comprenant un transistor à canal P en série avec un transistor à canal N et les géométries (W/L) du transistor P et du transistor N de chacun des inverseurs étant choisies de telle sorte que le rapport entre les géométries des transistors P et N (T1 et T'1) du premier inverseur soit légèrement différent du rapport entre les géométries des transistors P et N (T2 et T'2) du deuxième inverseur, le rapport entre les géométries des transistors P et N du troisième inverseur étant compris entre les deux premiers rapports.

3. Comparateur selon la revendication 2, caractérisé en ce que les inverseurs comprennent un transistor à canal P ayant son drain relié à une tension d'alimentation Vcc et sa grille commandée par une tension de référence Vref, et un transistor à canal N ayant sa source reliée à la masse, sa grille constituant l'entrée de l'inverseur et son drain étant relié au drain du transistor à canal P, la tension de référence Vref étant la même pour tous les inverseurs, et la sortie de l'inverseur étant prise sur les drains réunis des deux transistors qui composent l'inverseur.

4. Comparateur selon la revendication 2, caractérisé en ce que les inverseurs comprennent un transistor à canal P en série avec un transistor à canal N, l'entrée de l'inverseur étant constituée par les grilles réunies des deux transistors et la sortie étant constituée par les drains réunis des transistors.

5. Comparateur selon l'une des revendications 2 à 4, caractérisé en ce qu'il comporte une première capacité (C') reliée entre l'entrée de signal et l'entrée d'un premier inverseur, une deuxième capacité (C'') reliée entre l'entrée de signal et l'entrée d'un second inverseur, le comparateur comportant un troisième inverseur ayant son entrée rebouclée sur sa sortie et servant à établir une première tension de polarisation Vbias + v sur l'entrée du premier inverseur, et un quatrième inverseur ayant son entrée rebouclée sur sa sortie pour établir une deuxième tension de polarisation Vbias - v' sur l'entrée du deuxième inverseur, le rapport entre les géométries des transistors composant le troisième inverseur étant différent du rapport entre les géométries des transistors composant le quatrième inverseur.

## Patentansprüche

1. Gegen Rauschen geschützter Schwellenwertkomparator mit einem Signaleingang (E) zum Empfangen eines Signals mit variablem Pegel, gekennzeichnet durch wenigstens eine Eingangskapazität (C), die mit dem Signaleingang (E) verbunden ist, zwei Invertierglieder mit Schwellenwert (I1, 12), die jeweils einen mit dem Kondensator (C) verbundenen Eingang aufweisen, wobei diese Invertierglieder (I1, 12) nahe beieinanderliegende Kippschwellenwerte aufweisen, die einer Eingangsspannung Vbias + v für den einen und Vbias - v' für den anderen haben, wobei v und v' klein gegenüber der Versorgungsspannung Vcc des Komparators sind, wobei die Ausgänge der Invertierglieder (I1, 12) an einen Kippeingang eines Flipflops (B) vom Typ RS bzw. an den Rückstelleingang (R1) dieses Flipflops (B) angeschlossen sind, so daß bei einer Änderung des Zustandes eines der Invertierglieder als Folge des Überschreitens von Vbias + v durch das Eingangssignall das Kippen des Flipflops (B) und bei einer Änderung des Zustandes des anderen Invertierglieds als Folge der Rückkehr des Eingangssignals unter Vbias - v' das Rücksetzen hervorgerufen wird.

2. Komparator nach Anspruch 1, dadurch gekennzeichnet, daß die Spannung Vbias durch den Ausgang wenigstens eines dritten Invertierglieds (T3, T'3) festgelegt wird, dessen Eingang mit seinem Ausgang verbunden ist, wobei dieser Ausgang mit den Eingängen der zwei ersten Invertierglieder verbunden ist, wobei jedes der drei Invertierglieder einen P-Kanal-Transistor in Serie mit einem N-Kanal-Transistor enthält und wobei die geometrischen Abmessungen (W/L) des P-Kanal-Transistors und des N-Kanal-Transistors jedes Invertierglieds so gewählt sind, daß das Verhältnis zwischen den geometrischen Abmessungen der Transistoren P und N (T1 und T'1) des ersten Invertierglieds geringfügig verschieden vom Verhältnis der geometrischen Parameter der Transistoren P und N (T2 und T'2) des zweiten Invertierglieds sind, während das Verhältnis zwischen den geometrischen Parametern der Transistoren P und N des dritten Invertierglieds zwischen den zwei ersten Verhältnissen liegen.

3. Komparator nach Anspruch 2, dadurch gekennzeichnet, daß die Invertierglieder einen P-Kanal-Transistor enthalten, dessen Drain-Anschluß an eine Versorgungsspannung Vcc und dessen Gate-Anschluß an eine Referenzspannung Vref gelegt sind, und einen N-Kanal-Transistor enthalten, dessen Source-Anschluß an Masse liegt, dessen Gate-Anschluß den Eingang des Invertierglieds bildet und dessen Drain-Anschluß mit dem Drain-Anschluß des P-Kanal-Transistors verbunden ist, wobei die Referenzspannung Vref für alle Invertierglieder gleich ist, und wobei der Ausgang des Invertierglieds von den miteinander verbundenen Drain-Anschlüssen der zwei das Invertierglied bildenden Transistoren abgegriffen wird.

4. Komparator nach Anspruch 2, dadurch gekennzeichnet, daß die Invertierglieder einen in Serie mit einem N-Kanal-Transistor liegenden P-Kanal-Transistor enthalten, wobei der Eingang des Invertierglieds von den miteinander verbundenen Gate-Anschlüssen der zwei Transistoren gebildet ist, während der Ausgang von den verbundenen Drain-Anschlüssen der Transistoren gebildet ist.

5. Komparator nach einem der Ansprüche 2 bis 4, gekennzeichnet durch eine erste Kapazität (C'), die zwischen dem Signaleingang und dem Eingang eines ersten Invertierglieds angeschlossen ist, eine zweite Kapazität (C''), die zwischen dem Signaleingang und dem Eingang eines zweiten Invertierglieds angeschlossen ist, wobei der Komparator ein drittes Invertierglied enthält, dessen Eingang mit seinem Ausgang verbunden ist und das dazu dient, am Eingang des ersten Invertierglieds eine erste Vorspannung Vbias + v zu erzeugen, und ein viertes Invertierglied, dessen Eingang mit seinem Ausgang verbunden ist, um am Eingang des zweiten Invertierglieds eine zweite Vorspannung Vbias - v' zu erzeugen, wobei das Verhältnis zwischen den geometrischen Parametern der Transistoren, die das dritte Invertierglied bilden, vom Verhältnis der geometrischen Parameter der das vierte Invertierglied bildenden Transistoren verschieden ist.

## Claims

1. A threshold comparator protected from noise and comprising a signal input (E) adapted to receive a variable level signal, characterised in that it includes at least one input capacitor (C) connected to the signal input (E), two threshold inverters (I1, I2) each having an input connected to the capacitor (C), the said inverters (I1, I2) having switching thresholds close to each other, which correspond to an input voltage Vbias + v in respect of one, and Vbias - v' in respect of the other, where v and v' are small by comparison with the supply voltage Vcc of the comparator, one of the outputs of the inverters (I1, I2) being connected to the switching input (S1) of an RS type flip-flop (B), the other being connected to the restoration input (R1) of the said flip-flop (B) in such a way as to cause the flip-flop (B) to switch over when a change takes place in the state of one of the inverters due to Vbias + v being exceeded by the input signal, and to switch back when a change takes place in the state of the other inverter as a result of the input signal reverting to a value below Vbias - v'.

2. A comparator according to Claim 1, characterised in that the voltage Vbias is defined by the output of at least one third inverter (T3, T'3) having its input looped on to its output, this output being connected to the inputs of the two first inverters, with each of the three inverters comprising a P-channel resistor in series with an N-channel transistor, and the geometries (W/L) of the P transistor and the N transistor of each of the inverters being so selected that the ratio between the geometries of the P and N transistors (T1 and T'1) of the first inverter is slightly different from the ratio between the geometries of the P and N transistors (T2 and T'2) of the second inverter, the ratio between the geometries of the P and N transistors of the third inverter being intermediate between the two first ratios.

3. A comparator according to Claim 2, characterised in that the inverters include a P-channel transistor having its drain connected to a supply voltage Vcc and its gate controlled by a reference voltage Vref, and an N-channel transistor having its source connected to earth, with its gate constituting the input of the inverter and its drain being connected to the drain of the P-channel transistor, the reference voltage Vref being the same for all the inverters, and the output of the inverter being taken from the interconnected drains of the two transistors that constitute the inverter.

4. A comparator according to Claim 2, characterised in that the inverters include a P-channel transistor in series with an N channel transistor, the input of the inverter being constituted by the interconnected gates of the two transistors and its output being constituted by the interconnected drains of the transistors.

5. A comparator according to one of Claims 2 to 4, characterised in that it includes a first capacitor (C') connected between the signal input and the input of a first inverter, and a second capacitor (C'') connected between the signal input and the input of a second inverter, the comparator including a third inverter having its input looped on to its output and serving to set up a first polarisation voltage Vbias + v on the input of the first inverter, and a fourth inverter having its input looped on to its output so as to set up a second polarisation voltage Vbias - v' on the input of the second inverter, the ratio between the geometries of the transistors constituting the third inverter being different from the ratio between the geometries of the transistors constituting the fourth inverter.
